# DEMANDE DE BREVET EUROPEEN

(11) **EP 2 360 839 A1**
(43) Date de publication de la demande: **24.08.2011**
(21) Numéro de dépôt: 11153952.4
(22) Date de dépôt: 10.02.2011
(51) Int. Cl.: H03M 3/02

(54) **Convertisseur analogique/numérique a temps continu.**

(30) Priorité: 15.02.2010 FR 1051011
(71) Demandeur: STmicroelectronics SA, 92120 Montrouge (FR); Centre National de la Recherche Scientifique (CNRS), 75016 Paris (FR)
(72) Inventeur: Belot, Didier, 38140, RIVES (FR); Begueret, Jean-Baptiste, 33000, BORDEAUX (FR); Deval, Yann, 33800, BORDEAUX (FR); Dallet, Dominique, 33140, VILLENAVE D'ORNON (FR); Mariano, André, 33800, BORDEAUX (FR)
(74) Mandataire: Zapalowicz, Francis

(57) **Abrégé**

Convertisseur analogique/numérique à temps continu, comprenant un modulateur du type sigma delta (MSD1) configuré pour recevoir un signal d'entrée analogique (x(t)) et comprenant des moyens de filtrage passe-haut (MF) dont la fréquence de coupure est égale à la moitié de la fréquence d'échantillonnage (Fs) du moyen de quantification (QTZ) dudit modulateur (MSD1).

## Description

L'invention concerne la conversion à temps continu de signaux analogiques en signaux numériques et s'applique avantageusement mais non limitativement dans le domaine de la radiofréquence, par exemple en téléphonie mobile, dans lequel les circuits radiofréquences utilisent largement des dispositifs de conversion analogique/numérique, tant à l'émission qu'à la réception.

Ces dispositifs de conversion sont généralement réalisés au sein de circuits intégrés. Ils peuvent être à temps continu (ou CT : «continuous time» selon une dénomination anglosaxonne communément utilisée par l'homme du métier) ou encore à temps discret (ou DT: «discrete time» selon une dénomination anglosaxonne communément utilisée par l'homme du métier).

Généralement, on effectue cette conversion à l'aide d'un modulateur sigma delta car il offre une bonne résolution de conversion et repousse le bruit de quantification en dehors de la bande utile du signal.

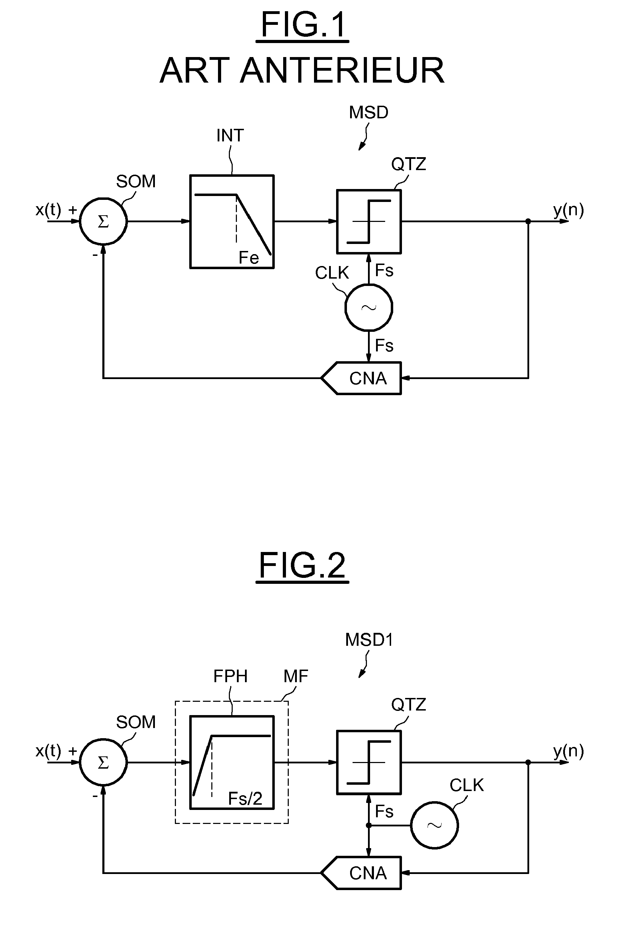

La figure 1 illustre schématiquement un exemple de structure habituellement utilisée pour les modulateurs sigma delta au sein d'un convertisseur à temps continu CT.

La structure des modulateurs sigma delta est généralement basée sur la combinaison d'un intégrateur et d'un sommateur, l'ensemble étant rebouclé. Le schéma d'un modulateur sigma delta est donc celui d'un système asservi.

Le modulateur sigma delta MSD comporte en tête un sommateur SOM (soustracteur) recevant un signal d'entrée analogique x(t) ayant une fréquence Fe. Ce soustracteur est suivi ici d'un intégrateur INT dont la sortie est reliée à l'entrée d'un moyen de quantification QTZ (échantillonneur) dont la sortie constitue la sortie du modulateur. La sortie du moyen de quantification QTZ est rebouclée sur l'entrée négative du sommateur SOM par l'intermédiaire d'un convertisseur numérique/analogique CNA. Le moyen de quantification QTZ transforme le signal issu de l'intégrateur INT en un signal numérique y(n). En outre, le modulateur MSD comprend un générateur d'horloge CLK pour générer une fréquence d'échantillonnage Fs destinée au moyen de quantification QTZ et au convertisseur CNA.

La modulation « delta » est basée sur la quantification de la modification du signal analogique d'entrée x(t).

La présence d'un intégrateur « sigma » dans le modulateur confère au modulateur la dénomination de modulateur « sigma delta ».

L'intégrateur comprend généralement un filtre passe-bas.

Cela étant, il existe également des modulateurs sigma delta passe-bande qui comportent, à la place d'un intégrateur, un filtre passe-bande. Ces modulateurs, bien qu'ils ne possèdent pas d'intégrateur, gardent toujours par abus de langage la dénomination « modulateur sigma delta ».

En pratique, dans les applications radiofréquences on utilise un filtre passe-bande et une fréquence d'échantillonnage Fs qui est environ égale à quatre fois la fréquence du signal analogique d'entrée x(t). La fréquence d'échantillonnage étant très élevée, ce modulateur MSD ne permet pas de convertir des signaux analogiques hautes fréquences, en général la fréquence des signaux d'entrée est limitée à quelques giga hertz.

Par ailleurs, comme indiqué ci avant, pour convertir les signaux analogiques on peut également utiliser un convertisseur analogique/numérique à temps discret DT. Ces convertisseurs utilisent également des modulateurs de type sigma delta, mais contrairement à l'utilisation à temps continu décrite précédemment, ces modulateurs reçoivent en entrée un signal échantillonné. Ces convertisseurs comprennent en outre un premier mélangeur de fréquence situé en amont du modulateur pour d'une part échantillonner le signal analogique d'entrée et d'autre part transposer la fréquence du signal d'entrée autour d'une fréquence de porteuse. Puis le modulateur convertit le signal échantillonné reçu en un signal numérique de sortie. Ce convertisseur comprend également un deuxième mélangeur situé en sortie du modulateur pour transposer à nouveau la fréquence du signal numérique de sortie autour de la fréquence du signal d'entrée.

L'échantillonnage du signal analogique d'entrée permet d'utiliser une valeur de fréquence d'échantillonnage pour le modulateur sigma delta inférieure à celle utilisée dans le convertisseur à temps continu CT décrit précédemment. En effet, pour un convertisseur à temps discret DT, la fréquence d'échantillonnage est environ égale à deux fois la fréquence du signal analogique d'entrée.

Ces convertisseurs à temps discret DT ne permettent pas de convertir les signaux analogiques à des fréquences plus élevées que les convertisseurs à temps continu CT. En outre, ils ont une architecture complexe car ils utilisent deux mélangeurs de fréquence.

Selon un mode de réalisation, il est proposé un système pour convertir des signaux analogiques à la plus haute fréquence possible, qui soit peu coûteux et moins complexe que ceux décrits précédemment.

Avantageusement, il est proposé un convertisseur qui puisse convertir directement un signal analogique à l'aide d'un modulateur sigma delta adapté sans avoir à traiter le signal analogique d'entrée en amont du modulateur.

En outre, il peut être avantageux de réduire les bruits à basses fréquences liés au traitement du signal analogique lors de sa conversion en signal numérique.

Selon un aspect, il est proposé un convertisseur analogique/numérique à temps continu, comprenant un modulateur du type sigma delta configuré pour recevoir un signal d'entrée analogique.

Ce modulateur comprend des moyens de filtrage passe-haut dont la fréquence de coupure est égale à la moitié de la fréquence d'échantillonnage du moyen de quantification dudit modulateur.

Ainsi, on convertit directement le signal analogique d'entrée à hautes fréquences, réduisant la complexité du convertisseur.

Avantageusement, on n'utilise pas de mélangeurs pour traiter le signal d'entrée en amont du modulateur.

Grâce à un moyen de filtrage passe-haut, on augmente la bande passante du convertisseur pour une fréquence d'échantillonnage du modulateur donnée.

La fréquence d'échantillonnage du modulateur sigma delta peut être avantageusement environ égale à deux fois la fréquence du signal analogique d'entrée.

Les moyens de filtrage passe-haut peuvent être réalisés à l'aide d'un simple filtre passe-haut ou bien à partir d'un ou de plusieurs résonateurs.

Ainsi, selon un mode de réalisation, le modulateur comprend au moins un sommateur, et les moyens de filtrage comprennent au moins un bloc comportant un résonateur et un amplificateur à gain variable couplé entre la sortie du moyen de quantification et une entrée du au moins un sommateur, le gain dudit amplificateur à gain variable étant fixé à une valeur pour laquelle la fréquence de résonance dudit résonateur est égale à ladite fréquence de coupure.

Ainsi, de par l'utilisation d'un résonateur, on augmente la précision des moyens de filtrage, c'est-à-dire qu'on rejette plus efficacement le bruit à basse fréquence en dehors de la bande de fréquence utile du signal analogique. On notera que cette précision croît avec le nombre de résonateurs utilisés.

Les résonateurs permettent d'obtenir un gain du signal à la fréquence de résonance du résonateur qui est supérieur au gain d'un filtre passe-haut classique.

Par ailleurs, les amplificateurs à gain variable permettent d'adapter le modulateur sigma delta en fonction de la fréquence du signal d'entrée.

Selon un autre mode de réalisation, le bloc comprend au moins un autre amplificateur à gain variable, les gains de tous les amplificateurs dudit bloc étant respectivement fixés à des valeurs pour lesquelles la fréquence de résonance dudit résonateur est égale à ladite fréquence de coupure.

On améliore ainsi la précision de chaque résonateur.

Le modulateur peut comprendre en outre un moyen de retard couplé entre la sortie du moyen de quantification et l'entrée de l'un des amplificateurs dudit bloc et configuré pour retarder le signal numérique de sortie du moyen de quantification d'un retard égal à la moitié de la période d'échantillonnage du moyen de quantification.

Selon encore un autre mode de réalisation, les moyens de filtrage comprennent au moins un autre bloc.

Le convertisseur tel que définit ci-dessus peut être réalisé sous forme intégrée au sein d'un circuit intégré. Les différents composants du convertisseur peuvent être réalisés sous forme de circuits spécifiques logiques ou autres, ou bien sous forme de modules logiciels au sein d'un microprocesseur.

On notera ici que la conception des filtres passe-haut sur circuits intégrés, en particulier en technologie CMOS, est plus facile à réaliser que pour des filtres passe-bande.

Selon un autre aspect, il est proposé un appareil de communication sans fil comportant un convertisseur tel que définit ci-dessus.

D'autres avantages et caractéristiques apparaîtront à l'examen de la description détaillée de modes de réalisation de l'invention, nullement limitatifs, et des dessins annexés sur lesquels :
- la figure 1, déjà décrite, illustre un modulateur sigma delta utilisé dans les convertisseurs à temps continu CT selon l'art antérieur;
- la figure 2 illustre de façon schématique un mode de réalisation d'un convertisseur analogique/numérique à temps continu selon l'invention;
- les figures 3 et 4 illustrent de façon schématique d'autres modes de réalisation d'un convertisseur analogique/numérique à temps continu; et
- la figure 5 illustre de façon schématique un exemple d'un appareil de communication sans fil incorporant un convertisseur à temps continu.

Sur la figure 2, on a représenté, de manière schématique, un mode de réalisation d'un convertisseur analogique/numérique à temps continu selon l'invention comprenant un modulateur sigma delta MSD1 dont la fréquence d'échantillonnage Fs du moyen de quantification QTZ est environ égale à deux fois la fréquence Fe du signal analogique d'entrée x(t).

Par ailleurs, le convertisseur sigma delta comprend un filtre décimateur, non représenté a des fins de simplification, couplé à la sortie du moyen de quantification QTZ.

Le modulateur MSD1 comporte des moyens de filtrage passe-haut MF.

Ces moyens de filtrage passe-haut MF comprennent ici un filtre passe-haut FPH dont la fréquence de coupure Fc est environ égale à la moitié de la fréquence d'échantillonnage Fs du moyen de quantification QTZ. Ce moyen de filtrage du type passe-haut permet en outre d'éliminer le bruit en basse fréquence.

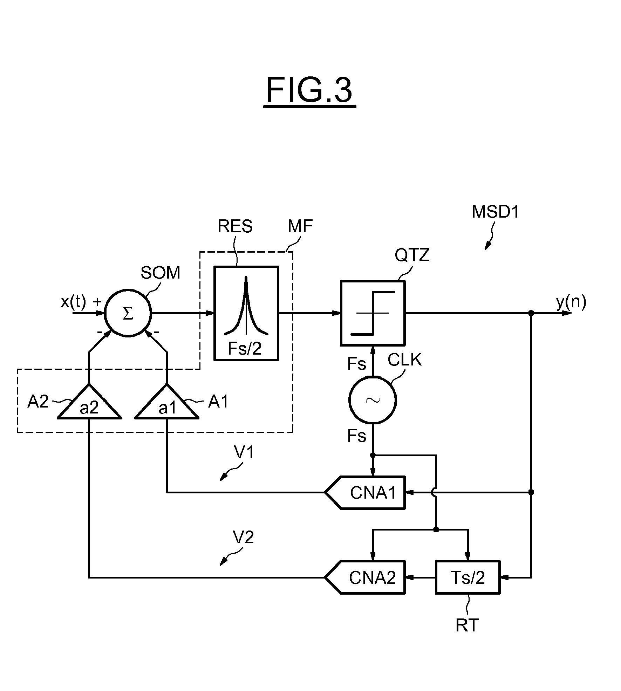

La figure 3 illustre de façon schématique un autre mode de réalisation du convertisseur analogique/numérique à temps continu selon l'invention. Dans ce mode de réalisation, les moyens de filtrage MF comprennent un bloc comportant un résonateur RES, un premier amplificateur A1 à gain variable a1 et un deuxième amplificateur A2 à gain variable a2. On obtient ainsi un moyen de filtrage passe-haut du deuxième ordre, car celui-ci comprend un résonateur RES à deux paramètres variables qui sont les gains variables a1,a2.

Le modulateur MSD 1 comprend deux voies V1, V2 pour reboucler le signal numérique de sortie y(n) sur respectivement deux entrées négatives du sommateur SOM.

La première voie V1 comprend un premier convertisseur numérique/analogique CNA1 couplé entre la sortie du moyen de quantification QTZ et le premier amplificateur A1, ce dernier étant couplé à la première entrée négative du sommateur SOM.

La deuxième voie V2 comprend un deuxième convertisseur numérique/analogique CNA2 couplé entre un moyen de retard RT et le deuxième amplificateur A2, ce dernier étant couplé à la deuxième entrée négative du sommateur SOM. Le moyen de retard RT est en outre couplé entre la sortie du moyen de quantification QTZ et le deuxième convertisseur numérique/analogique CNA2. Ce moyen de retard RT permet de retarder le signal numérique y(n) sortant du moyen de quantification QTZ d'une période égale à la moitié de la période d'échantillonnage Ts du modulateur MSD1.

On notera qu'un résonateur est un système qui oscille naturellement à une fréquence précise Fr qui est sa fréquence de résonance.

Les gains variables a1,a2 sont déterminés en fonction de la fréquence Fe du signal analogique d'entrée x(t) pour obtenir une fréquence de résonance Fr du résonateur qui soit environ égale à la moitié de la fréquence d'échantillonnage Fs du modulateur MSD1.

On notera également que pour un filtre passe-haut classique, le gain est généralement compris entre 20 et 30. Au contraire, pour un résonateur, le gain est compris entre 300 et 400. Par ailleurs, les résonateurs sont précis et ont un écart de résonance de ± 3 dB (décibels).

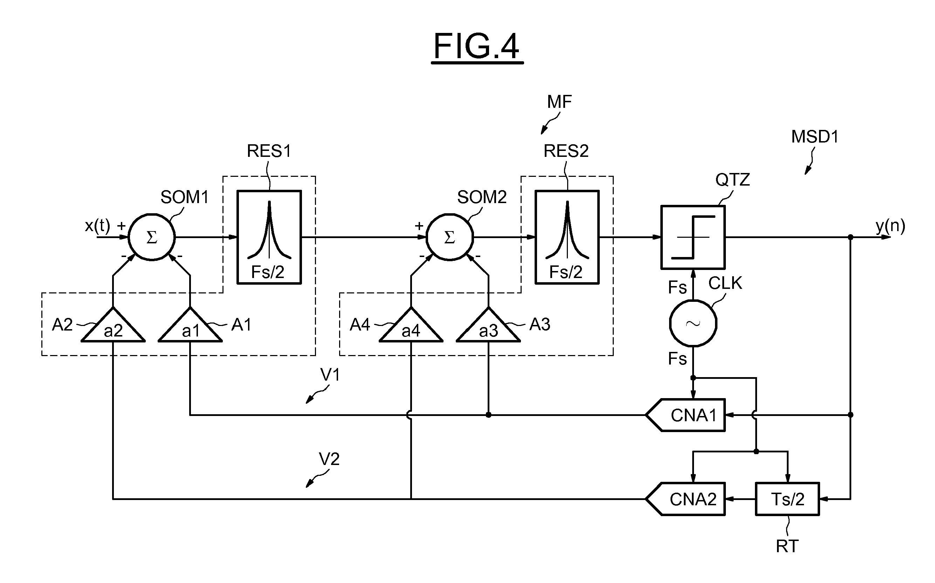

La figure 4 illustre une représentation schématique d'un autre mode de réalisation du convertisseur analogique/numérique à temps continu. On a également reporté sur cette figure 4 certains éléments décrits aux figures précédentes.

Dans cet autre mode de réalisation, les moyens de filtrage FPH comprennent deux blocs comportant respectivement deux résonateurs RES1, RES2 montés en série, de manière à obtenir un moyen de filtrage passe-haut du quatrième ordre. Chaque résonateur est précédé d'un sommateur SOM1,SOM2. Le nombre de blocs, et en particulier le nombre de résonateurs montés en série, n'est pas limitatif, et l'on peut réaliser des moyens de filtrage qui comprennent plus de deux résonateurs pour améliorer la précision des moyens de filtrage MF. Cependant, si on augmente le nombre de résonateurs, on augmente également le temps de traitement pour la conversion du signal analogique x(t). C'est pourquoi l'utilisation de deux résonateurs offre un bon compromis entre précision et temps de traitement pour la conversion numérique.

Par ailleurs, les moyens de filtrage MF comprennent, dans un premier bloc, un premier amplificateur A1 à gain variable a1 et un deuxième amplificateur A2 à gain variable a2. Ces moyens de filtrage MF comprennent en outre dans un deuxième bloc, un troisième amplificateur A3 à gain variable a3 et un quatrième amplificateur A4 à gain variable a4.

A titre d'exemple, non limitatif, le convertisseur analogique/numérique à temps continu peut comprendre un modulateur sigma delta muni de deux résonateurs pour convertir un signal analogique d'entrée ayant une fréquence Fe= 2 GHz, avec une fréquence d'échantillonnage Fs= 4 GHz.

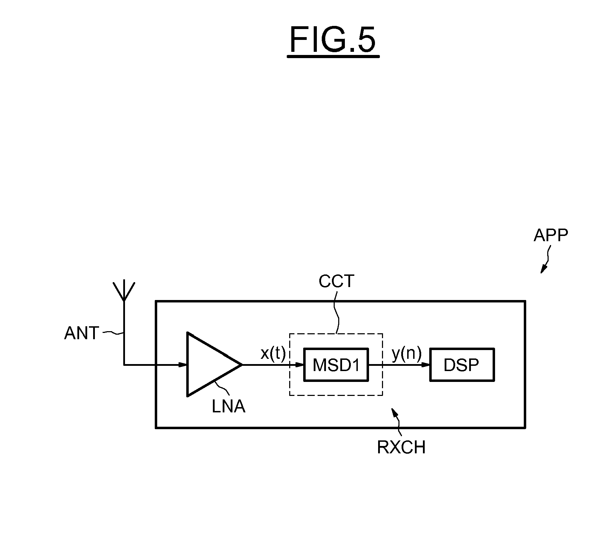

Sur la figure 5, on a représenté de façon schématique un appareil de communication sans fil APP.

Cet appareil de communication sans fil APP comprend une antenne ANT pour émettre et recevoir des signaux de communication avec une station de base distante.

Cet appareil APP comporte classiquement une chaîne de réception RXCH et une chaîne de transmission, non représentée ici à des fins de simplification.

La chaîne de réception RXCH comprend une partie analogique comportant notamment un amplificateur faible bruit LNA connecté à un convertisseur analogique/numérique à temps continu CCT qui comporte un modulateur sigma delta MSD1 du type de celui décrit ci avant pour convertir le signal analogique d'entrée x(t) en un signal numérique y(n) destiné à un processeur de signal numérique DSP.

## Revendications

1. Convertisseur analogique/numérique à temps continu, comprenant un modulateur du type sigma delta (MSD1) configuré pour recevoir un signal d'entrée analogique (x(t)), **caractérisé en ce que** ledit modulateur (MSD1) comprend des moyens de filtrage passe-haut (MF) dont la fréquence de coupure est égale à la moitié de la fréquence d'échantillonnage (Fs) du moyen de quantification (QTZ) dudit modulateur (MSD1).

2. Convertisseur selon la revendication 1, dans lequel le modulateur (MSD1) comprend au moins un sommateur (SOM1,SOM2), et les moyens de filtrage (MF) comprennent au moins un bloc comportant un résonateur (RES1,RES2) et un amplificateur (A1,A3) à gain variable couplé entre la sortie du moyen de quantification (QTZ) et une entrée du au moins un sommateur (SOM1,SOM2), le gain dudit amplificateur (A1,A3) à gain variable étant fixé à une valeur pour laquelle la fréquence de résonance (Fr1,Fr2) dudit résonateur (RES1,RES2) est égale à ladite fréquence de coupure.

3. Convertisseur selon la revendication 2, dans lequel le bloc comprend au moins un autre amplificateur (A2,A4) à gain variable, les gains de tous les amplificateurs (A2,A4) dudit bloc étant respectivement fixés à des valeurs pour lesquelles la fréquence de résonance (Fr1,Fr2) dudit résonateur (RES1,RES2) est égale à ladite fréquence de coupure.

4. Convertisseur selon la revendication 3, dans lequel ledit modulateur (MSD1) comprend en outre un moyen de retard (RT) couplé entre la sortie du moyen de quantification (QTZ) et l'entrée de l'un des amplificateurs (A2,A4) dudit bloc et configuré pour retarder le signal numérique de sortie (y(n)) du moyen de quantification (QTZ) d'un retard égal à la moitié de la période d'échantillonnage (Ts) du moyen de quantification (QTZ).

5. Convertisseur selon l'une des revendications 2 à 4, dans lequel les moyens de filtrage (MF) comprennent au moins un autre bloc.

6. Convertisseur selon l'une des revendications 1 à 5, réalisé sous forme intégrée au sein d'un circuit intégré.

7. Appareil de communication sans fil comportant un convertisseur selon l'une des revendications 1 à 6.
